# EUROPEAN PATENT SPECIFICATION

(11) **EP 2 261 995 B1**
(45) Date of publication and mention of the grant of the patent: **22.05.2019**
(21) Application number: 09721439.9
(22) Date of filing: 18.03.2009
(51) Int. Cl.: H01L 31/0224, H01L 31/072, H01L 31/075, H01L 31/0747

(54) **SOLAR CELL AND METHOD FOR MANUFACTURING THE SAME**
SOLARZELLE UND VERFAHREN ZU IHRER HERSTELLUNG
CELLULE SOLAIRE ET SON PROCÉDÉ DE FABRICATION

(30) Priority: 19.03.2008 JP 2008072484
(43) Date of publication of application: 15.12.2010
(73) Proprietor: Panasonic Intellectual Property Management Co., Ltd., Osaka-shi, Osaka 540-6207 (JP)
(72) Inventor: FUJISHIMA, Daisuke, Moriguchi City Osaka 570-8677 (JP)
(74) Representative: Mewburn Ellis LLP
(86) International application number: PCT/JP2009/055312
(87) International publication number: WO 2009/116580

(56) References cited:
- EP-A2- 0 204 554
- EP-A2- 0 246 027
- WO-A1-2008/059857
- WO-A1-2008/146693
- JP-A- 2006 128 630
- JP-A- 2007 288 043
- TAKASHI KOIDA ET AL: "Hydrogen-doped In 2 O 3 as High-mobility Transparent Conductive Oxide", JPN. J. APPL. PHYS, vol. 46, no. 28, 13 July 2007 (2007-07-13) , pages L685-L687, XP055189957,
- TAKASHI KOIDA ET AL: "Reduction of optical loss in hydrogenated amorphous silicon/crystalline silicon heterojunction solar cells by high-mobility hydrogen-doped In2O3 transparent conductive oxide", APPLIED PHYSICS EXPRESS, JAPAN SOCIETY OF APPLIED PHYSICS; JP, JP, vol. 1, no. 4, 1 April 2008 (2008-04-01), pages 41501-1, XP001517131, ISSN: 1882-0778, DOI: 10.1143/APEX.1.041501

## Description

The present invention relates to a solar cell including transparent conductive films formed on a photoelectric conversion body and a method for manufacturing the same.

### BACKGROUND ART

Solar cells are expected as a new source of energy, because solar cells are capable of directly converting light, which comes from the sun as a clean, unlimited source of energy, to electricity.

A solar cell includes a photoelectric conversion body which has an n-type semiconductor layer and a p-type semiconductor layer and receives light to generate photogenerated carriers. The carriers are extracted from the photoelectric conversion body through electrodes formed on the n- and p-type semiconductor layers. Each electrode to be used has a layered structure of a transparent conductive film and a metallic layer in some cases. In such a case, it is desirable that the transparent conductive film have low electric resistivity.

Herein, there is proposed a technique to form a transparent conductive film in an atmosphere containing hydrogen (see Japanese Patent Application Publication No. Hei 2-54755) . With this technique, hydrogen atoms introduced into the transparent conductive film terminate dangling bonds of atoms constituting the transparent conductive film. The electric resistivity of the transparent conductive film can be therefore reduced.

However, if transparent conductive films are formed on the photoelectric conversion body by using the above technique, the surface characteristics of the photoelectric conversion body could be degraded. Specifically, hydrogen radicals having reducing properties could degrade the surfaces of the n- and p-type semiconductor layers when the transparent conductive films are formed.

The present invention was made in the light of the aforementioned problem, and an object of the present invention is to provide a solar cell with the surface characteristics of the photoelectric conversion body prevented from being degraded and a method for manufacturing the same.

EP0204554A2 discloses a photoconductive device that is provided by using at least one zinc oxide transparent conductive layer in conjunction with a thin film amorphous silicon photoconductor. The zinc oxide layer can be used as the front contact, the back contact or both the front and back contacts of the photoconductive device.

### DISCLOSURE OF THE INVENTION

According to a first aspect of the present invention there is provided a solar cell as specified in claim 1.

In the solar cell according to the first aspect of the present invention, the hydrogen atom content of the first transparent conductive film formed on the first major surface on the n-type semiconductor layer side is lower than that of the second transparent conductive film formed on the second major surface. This can reduce the effect of hydrogen radicals on the surface of the n-type semiconductor layer forming the first major surface of the photoelectric conversion body. The degradation of the surface characteristics of the photoelectric conversion body can be therefore prevented.

The solar cell according to the first aspect of the present invention may optionally be as specified in any one of claims 2 to 4.

According to a second aspect of the present invention there is provided a method for manufacturing a solar cell as specified in claim 5.

The method according to the second aspect of the present invention may optionally be as specified in claim 6.

In the one characteristic of the present invention, the step B may be performed after the step A is performed.

### BRIEF DESCRIPTION OF THE DRAWINGS

Fig. 1 is a plan view of a solar cell 10 according to a first embodiment of the present invention on a second major surface side.
Fig. 2 is a cross-sectional view of the solar cell 10 according to the first embodiment of the present invention.
Fig. 3 is a cross-sectional view of a solar cell 10 according to a second embodiment of the present invention.
Fig. 4 is a cross-sectional view of a solar cell 20 according to a non-claimed example.
Fig. 5 is a view showing a relationship between thickness of an ITO film formed on an n-type amorphous silicon layer and a fill factor FF.

### BEST MODES FOR CARRYING OUT THE INVENTION

Next, the embodiments of the invention are described with reference to the drawings. In the following description of the drawings, identical or similar reference numerals are assigned to identical or similar components. However, the drawings are schematic, thus it should be noted that the dimensions are not shown to scale. Accordingly, specific dimensions should be recognized in consideration of the following description. Also, there are inevitably included some portions of the drawings between which a dimensional relationship and/or a scale are inconsistent.

### [First Embodiment]

### <Schematic Structure of Solar Cell>

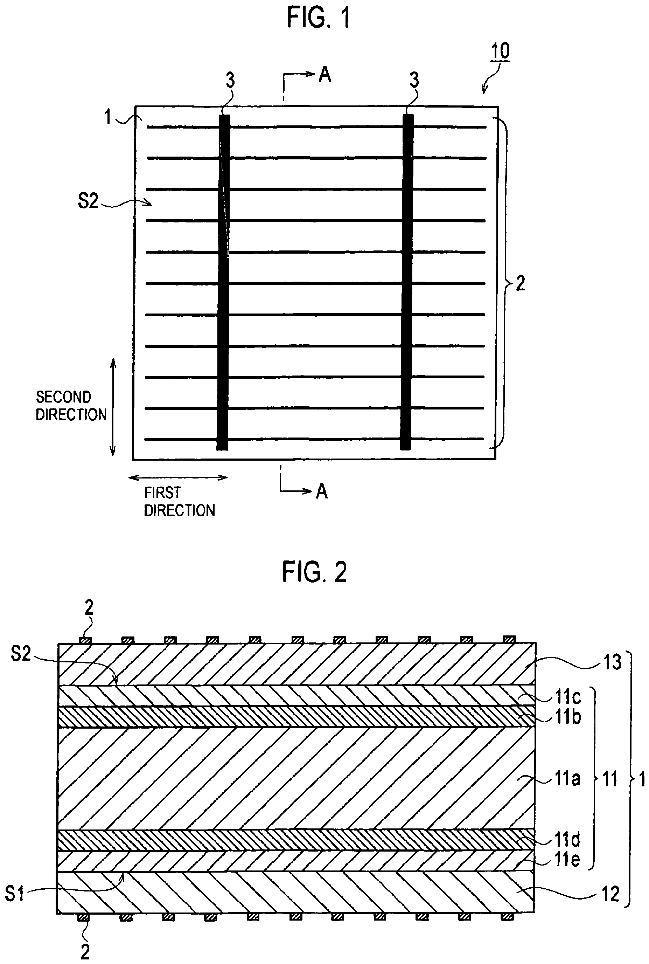

The schematic structure of a solar cell 10 according to a first embodiment of the present invention is described below with reference to Figs. 1 and 2. Fig. 1 is a plan view of the solar cell 10 on a second major surface S2 side. Fig. 2 is an A-A cross-sectional view of Fig. 1.

As shown in Figs. 1 and 2, the solar cell 10 includes a solar cell substrate 1, fine-line electrodes 2, and connecting electrodes 3.

As shown in Fig. 2, the solar cell substrate 1 includes a photoelectric conversion body 11, a first transparent conductive film 12, and a second transparent conductive film 13. The photoelectric conversion body 11 is configured to generate photogenerated carriers upon receiving light. The solar cell substrate 1 includes a first major surface S1 (the lower surface in Fig. 2) and a second major surface S2 (the upper surface in Fig. 2) provided on the opposite side to the first major surface S1. The structure of the solar cell substrate 1 is described later.

The fine-line electrodes 2 are collecting electrodes configured to collect photogenerated carriers from the photoelectric conversion body 11. The fine-line electrodes 2 are formed on the second major surface S2 of the solar cell substrate 1 along a first direction substantially parallel to a side of the solar cell substrate 1 as shown in Fig. 1. Some of the plurality of fine-line electrodes 2 are arranged substantially at regular intervals in a second direction substantially orthogonal to the first direction. The other fine-line electrodes 2 (not shown) are formed on the first major surface S1 of the solar cell substrate 1 in a similar manner to those on the second major surface S2 of the solar cell substrate 1. The fine-line electrodes 2 formed on the second major surface S2 of the solar cell substrate 1 collect carriers from the photoelectric conversion body 11 through the second transparent conductive film 13 later described. The fine-line electrodes 2 formed on the first major surface S1 of the solar cell substrate 1 collect carriers from the photoelectric conversion body 11 through the first transparent conductive film 12 later described.

The fine-line electrodes 2 can be formed, for example, by printing resin-type conductive paste which includes a resin material as a binder and conductive particles such as silver particles as a filler or sintered-type conductive paste containing silver powder, glass frit, organic vehicle, organic solvent, and the like (so-called ceramic paste) by using a printing process. Each fine-line electrode 2 may be formed as a metallic film by deposition. The number and size of the fine-line electrodes 2 can be set to proper values in consideration of the size of the photoelectric conversion body 11 and the like.

The connecting electrodes 3 are electrodes connected to wiring materials (not shown) electrically connecting a plurality of the solar cells 10 in series or in parallel. The connecting electrodes 3 are formed on the second major surface S2 of the solar cell substrate 1 along the second direction as shown in Fig. 1. Accordingly, some of the connecting electrodes 3 intersect the plurality of fine-line electrodes 2 and are electrically connected to the plurality of fine-line electrodes 2. The other connecting electrodes 3 (not shown) are formed on the first major surface S1 of the solar cell substrate 1 in a similar manner to the first major surface S2 of the solar cell substrate 1. The connecting electrodes 3 can be formed by printing or deposition in a similar way to the fine-line electrodes 2. The number and size of the connecting electrodes 3 can be set to proper values in consideration of the size of the photoelectric conversion body 11 and the like.

### <Structure of Solar Cell Substrate>

Next, a description is given of an example of the structure of the solar cell substrate 1 according to the first embodiment of the present invention with reference to Fig. 2.

The solar cell substrate 1 includes the photoelectric conversion body 11 and the first and second transparent conductive films 12 and 13 as shown in Fig. 2.

The photoelectric conversion body 11 includes the first major surface S1 (the lower surface in Fig. 2) and the second major surface S2 (the upper surface in Fig. 2) provided on the opposite side to the first major surface S1. The photoelectric conversion body 11 receives light through the first or second major surface S1 or S2 of the photoelectric conversion body 11 to generate photogenerated carriers. Each of the photogenerated carriers refers to a pair of a hole and an electron generated upon the photoelectric conversion body 11 absorbing solar light.

The photoelectric conversion body 11 includes an n-type substrate 11a, an i-type semiconductor layer 11b, a p-type semiconductor layer 11c, an i-type semiconductor layer 11d, and an n-type semiconductor layer 11e as shown in Fig. 2.

The n-type substrate 11a is a main body of the photoelectric conversion body 11. For the n-type substrate 11a, an n-type single-crystalline silicon substrate is used.

The p-type semiconductor layer 11c is formed on the second major surface S2 side of the n-type substrate 11a with the i-type semiconductor layer 11b interposed therebetween. On the other hand, the n-type semiconductor layer 11e is formed on the first major surface S1 side of the n-type substrate 11a with the i-type semiconductor layer 11d interposed therebetween. In other words, the second major surface S2 of the photoelectric conversion body 11 is formed by the p-type semiconductor layer 11c, and the first major surface S1 of the photoelectric conversion body 11 is formed by the n-type semiconductor layer 11e.

For the i-type semiconductor layers 11b and 11d an i-type amorphous semiconductor layer can be used. For the p-type semiconductor layer layer 11c and the n-type semiconductor layer 11e a p-type amorphous semiconductor layer and an n-type amorphous semiconductor layer are used, respectively.

In such a case, it is preferable that the i-type semiconductor layers 11b and 11d constituted by i-type amorphous semiconductor layers have such thicknesses that the i-type semiconductor layers 11b and 11d substantially do not contribute to power generation. For example, the thicknesses of the i-type semiconductor layers 11b and 11d are preferably in a range from several Å to 250 Å. The amorphous semiconductors can be silicon-based semiconductors such as amorphous silicon, amorphous silicon carbide, amorphous silicon germanium, and microcrystalline silicon.

The structure of the photoelectric conversion body 11 is not limited to the aforementioned structure. For example, the photoelectric conversion body 11 does not need to include the i-type semiconductor layers 11b and 11d and may have another structure.

As shown in Fig. 2, the first transparent conductive film 12 is formed on the n-type semiconductor layer 11e forming the first major surface S1 of the photoelectric conversion body 11. The first transparent conductive film 12 has translucency and conductivity. For the first transparent conductive layer 12, a metal oxide such as indium oxide (In₂O₃), zinc oxide (ZnO), tin oxide (SnO₂), or titanium oxide (TiO₂) can be used. These metal oxides may be doped with a dopant such as tin (Sn), zinc (Zn), tungsten (W), antimony (Sb), titanium (Ti), cerium (Ce), zirconium (Zr), molybdenum (Mo), aluminum (Al), or gallium (Ga). The concentration of the dopant can be 0 to 20 wt%.

As shown in Fig. 2, the second transparent conductive film 13 is formed on the p-type semiconductor layer 11c forming the second major surface S2 of the photoelectric conversion body 11. The second transparent conductive film 13 has translucency and conductivity. Similarly to the first transparent conductive film 12, for the second transparent conductive film 13, a metal oxide such as indium oxide (In₂O₃), zinc oxide (ZnO), tin oxide (SnO₂), or titanium oxide (TiO₂) can be used. These metal oxides may be doped with a dopant such as tin (Sn), zinc (Zn), tungsten (W), antimony (Sb), titanium (Ti), cerium (Ce), zirconium (Zr), molybdenum (Mo), aluminum (Al), or gallium (Ga). The concentration of the dopant can be 0 to 20 wt%. The materials constituting the second transparent conductive film 13 may be either the same as or different from materials constituting the first transparent conductive film 12.

In this embodiment, the hydrogen atom content of the first transparent conductive film 12 is lower than that of the second transparent conductive film 13. Accordingly, a metal oxide formed in an atmosphere not containing hydrogen can be used for the first transparent conductive film 12 while a metal oxide formed in an atmosphere supplying hydrogen atoms (an atmosphere containing hydrogen) can be used for the second transparent conductive film 13.

### <Method for Manufacturing Solar Cell>

Next, a method for manufacturing the solar cell 10 according to the first embodiment of the present invention is described. First, the n-type substrate 11a is etched to form fine roughness on the first and second major surfaces S1 and S2 sides.

Next, the i-type and p-type semiconductor layers 11b and 11c are sequentially stacked on the second major surface S2 side of the n-type substrate 11a using CVD or the like. The i-type and n-type semiconductor layers 11d and 11e are sequentially stacked on the first major surface S1 side of the n-type substrate 11a in a similar manner. The photoelectric conversion body 11 is thus formed.

Next, the first transparent conductive film 12 is formed on the n-type semiconductor layer 11e by using a sputtering method or the like in an atmosphere not containing hydrogen such as an Ar and O₂ atmosphere. The atmosphere not containing hydrogen refers to an atmosphere not actively supplying hydrogen atoms. The hydrogen atom contents of the transparent conductive films formed in the atmosphere not containing hydrogen are about 1.0×10²⁰ to 5.2×10²⁰ (atoms/cc).

Next, by using a sputtering method or the like, the second transparent conductive film 13 is formed on the p-type semiconductor layer 11c in an atmosphere containing hydrogen. Specifically, the second transparent conductive film 13 is formed in an Ar, O₂, and H₂O atmosphere, an Ar, O₂, and H₂ atmosphere, or the like where hydrogen atoms are being supplied thereto. The hydrogen atom content of the second transparent conductive film 13 is therefore higher than that of the first transparent conductive film 12. The solar cell substrate 1 is thus formed. Preferably, the process to form the second transparent conductive film 13 is performed after the process to form the first transparent conductive film 12 is performed.

Next, epoxy-based thermosetting-type silver paste is placed on the second major surface S2 of the solar cell substrate 1 in a predetermined pattern by using a printing process such as screen printing or off-set printing. In a similar manner, epoxy-based thermosetting-type silver paste is placed on the first major surface S1 of the solar cell 1 in a predetermined pattern. The silver paste is heated under predetermined conditions for volatilization of the solvent and is then further heated for final drying. Herein, the predetermined patterns have the shapes corresponding to the fine-line electrodes 2 extending along the first direction and the connecting electrodes 3 extending along the second direction as shown in Fig. 1. The solar cell 10 is thus manufactured.

### <Operation and Effects>

In the solar cell 10 according to the first embodiment of the present invention, the first transparent conductive film 12 is formed on the n-type semiconductor layer 11e, which forms the first major surface S1 of the photoelectric conversion body 11, in the atmosphere not containing hydrogen. Moreover, the second transparent conductive film 13 is formed on the p-type semiconductor layer 11c, which forms the second major surface S2 of the photoelectric conversion body 11, in the atmosphere containing hydrogen. The hydrogen atom content of the first transparent conductive film 12 formed on the first major surface S1 of the photoelectric conversion body 11 is therefore lower than that of the second transparent conductive film 13 formed on the second major surface S2 of the photoelectric conversion body 11.

The applicant examined the influence of hydrogen radicals on the surfaces of the p-type and n-type semiconductor layer 11c and 11e in the case where the transparent conductive films were formed in the atmosphere containing hydrogen on the p-type semiconductor layer 11c forming the second major surface S2 of the photoelectric conversion body 11 and on the n-type semiconductor layer 11e forming the first major surface S1 of the photoelectric conversion body 11. As a result, the applicant found that the surface of the n-type semiconductor layer 11e was more likely to be degraded by hydrogen radicals.

Accordingly, the first transparent conductive film 12 is formed in the atmosphere not containing hydrogen on the n-type semiconductor layer 11e, the surface of which is more likely to be degraded in the atmosphere containing hydrogen, so that the surface of the n-type semiconductor layer 11e can be prevented from being degraded by hydrogen radicals. On the other hand, the second transparent conductive film 13 is formed on the p-type semiconductor layer 11c, which is less affected by hydrogen radicals in the atmosphere containing hydrogen than the n-type semiconductor layer 11e, with hydrogen atoms being actively introduced thereto. This can provide increased translucency and reduced electric resistivity to the second transparent conductive film 13. As described above, in the solar cell 10 according to the first embodiment of the present invention, it is possible to prevent the degradation of the surface characteristics of the photoelectric conversion body 11.

Moreover, since the second transparent conductive film 13 is formed on the p-type semiconductor layer 11c after the first transparent conductive film 12 is formed on the n-type semiconductor layer 11e, the surface of the n-type semiconductor layer 11e is protected by the first transparent conductive film 12. This can further reduce the influence of hydrogen radicals on the surface of the n-type semiconductor layer 11e when the second transparent conductive film 13 is formed in the atmosphere containing hydrogen.

### [Second Embodiment]

Hereinbelow, a second embodiment of the present invention is described. The following description is mainly about the difference between the aforementioned first embodiment and the second embodiment. Specifically, in the aforementioned first embodiment, the hydrogen atom content of the first transparent conductive film 12 on the n-type semiconductor layer 11e side is substantially the same as that of the first transparent conductive film 12 on the opposite side to the n-type semiconductor layer 11e. In contrast, in the second embodiment, the hydrogen atom content of the first transparent conductive film 12 on the n-type semiconductor layer 11e side is different from that of the first transparent conductive film 12 on the opposite side to the n-type semiconductor layer 11e. The schematic structure of the solar cell 10 according to the second embodiment of the present invention is substantially the same as that of the solar cell 10 according to the first embodiment, and the description thereof is omitted herein.

### <Structure of Solar Cell>

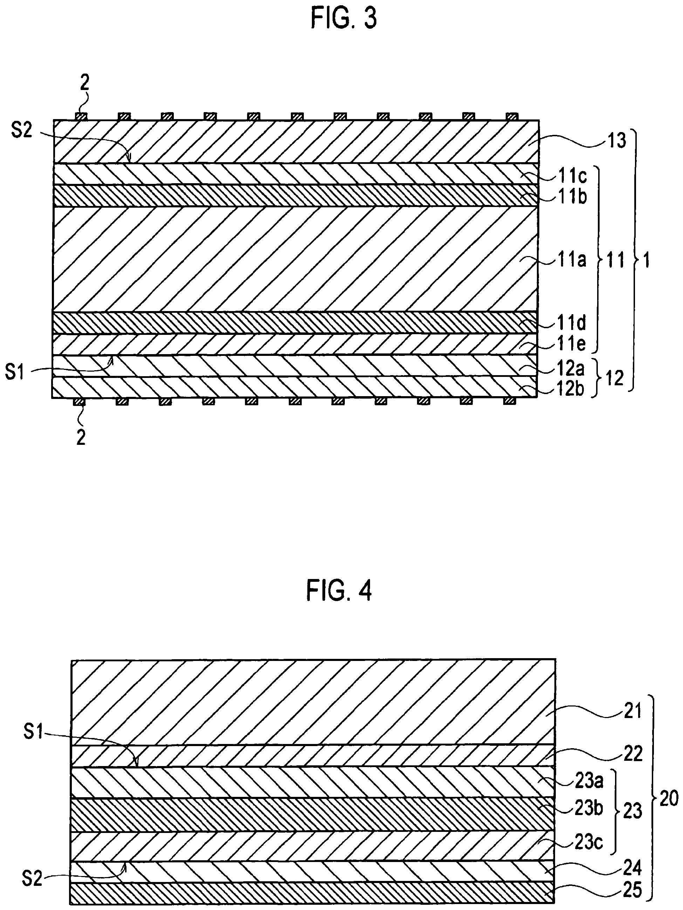

An example of the structure of the solar cell substrate 1 according to the second embodiment of the present invention is described with reference to Fig. 3.

The solar cell substrate 1 includes the photoelectric conversion body 11, the first transparent conductive film 12, and the second transparent conductive film 13 as shown in Fig. 3. The structures of the photoelectric conversion body 11 and second transparent conductive film 13 are substantially the same as those of the aforementioned first embodiment, and the description thereof is omitted.

The first transparent conductive film 12 includes a third transparent conductive film 12a and a fourth transparent conductive film 12b as shown in Fig. 3. The third transparent conductive film 12a is formed on the n-type semiconductor layer 11e forming the first major surface S1 of the photoelectric conversion body 11. The fourth transparent conductive film 12b is formed on the third transparent conductive film 12a. The third and fourth transparent conductive films 12a and 12b include translucency and conductivity. For the third and fourth transparent conductive films 12a and 12b, a metal oxide such as indium oxide (In₂O₃), zinc oxide (ZnO), tin oxide (SnO₂), or titanium oxide (TiO₂) can be used. These metal oxides may be doped with a dopant such as tin (Sn), zinc (Zn), tungsten (W), antimony (Sb), titanium (Ti), cerium (Ce), zirconium (Zr), molybdenum (Mo), aluminum (Al), or gallium (Ga). The concentration of the dopant can be 0 to 20 wt%.

In this embodiment, the hydrogen atom content of the fourth transparent conductive film 12b is higher than that of the third transparent conductive film 12a. In other words, the hydrogen atom content of a half of the first transparent conductive film 12 on the opposite side to the n-type semiconductor layer 11e is higher than that of the other half on the n-type semiconductor layer 11e side. Moreover, the hydrogen atom content of the third transparent conductive film 12a is lower than that of the second transparent conductive film 13. In other words, the hydrogen atom content of the half of the first transparent conductive film 12 on the n-type semiconductor layer 11e side is lower than that of the second transparent conductive film 13.

Accordingly, for example, for the third transparent conductive film 12a, a metallic oxide formed in the atmosphere not containing hydrogen can be used while a metallic oxide formed in the atmosphere supplying hydrogen atoms (the atmosphere containing hydrogen) in a similar manner to the second transparent conductive film 13 can be used for the fourth transparent conductive film 12b. The materials constituting the second, third, and fourth transparent conductive films 13, 12a, and 12b may be the same or different.

### <Method for Manufacturing Solar Cell>

Next, a method for manufacturing the solar cell 10 according to the second embodiment of the present invention is described.

First, the photoelectric conversion body 11 is formed in the same way as the aforementioned first embodiment. Next, the third transparent conductive film 12a is formed on the n-type semiconductor layer 11e, which forms the first major surface S1 of the photoelectric conversion body 11, by using a sputtering method or the like in the atmosphere not containing hydrogen such as an Ar and O₂ atmosphere.

Next, the second transparent conductive film 13 is formed on the p-type semiconductor layer 11c by using a sputtering method or the like in the atmosphere containing hydrogen. Specifically, the second transparent conductive film 13 is formed in an Ar, O₂, and water vapor atmosphere, an Ar, O₂, and hydrogen atmosphere, or the like where hydrogen atoms are being supplied. The hydrogen atom content of the second transparent conductive film 13 is therefore made higher than that of the third transparent conductive film 12a.

Next, the fourth transparent conductive film 12b is formed on the third transparent conductive film 12a by using a sputtering method or the like in the atmosphere containing hydrogen. Specifically, the fourth transparent conductive film 12b is formed in an Ar, O₂, and water vapor atmosphere, an Ar, O₂, and hydrogen atmosphere, or the like where hydrogen atoms are being supplied. The hydrogen atom content of the fourth transparent conductive film 12b is therefore made higher than that of the third transparent conductive film 12a. The first transparent conductive film 12 is thus formed. The solar cell substrate 1 is formed in such a manner.

Next, the fine-line electrodes 2 and connecting electrodes 3 are formed in the same way as the aforementioned first embodiment. The solar cell 10 is thus formed.

### <Operation and Effects>

In the solar cell 10 according to the second embodiment of the present invention, the first transparent conductive film 12 formed on the n-type semiconductor layer 11e includes the third and fourth transparent conductive films 12a and 12b. The third transparent conductive film 12a is formed on the n-type semiconductor layer 11e in the atmosphere not containing hydrogen, and the fourth transparent conductive film 12b is formed on the third transparent conductive film 12a in the atmosphere containing hydrogen.

Accordingly, it is possible to increase the translucency of the overall first transparent conductive film 12 and reduce the electrical resistivity thereof without degrading the surface of the n-type semiconductor layer 11e in comparison with the case where the hydrogen atom content of the first transparent conductive film 12 on the n-type semiconductor layer 11e side is substantially equal to that of the first transparent conductive film 12 on the opposite side to the n-type semiconductor layer 11e.

### <Other Embodiments>

The present invention has been described by using the embodiments of the present invention. However, it should not be understood that the description and drawings which constitute part of this disclosure limit the present invention. Instead, the scope of the present invention is defined by the appended claims.

A non-claimed example relates to thin film-type solar cells. Fig. 4 is a cross-sectional view of a thin film-type solar cell 20. As shown in Fig. 4, the thin film-type solar cell 20 includes a substrate 21 having translucency, a fifth transparent conductive film 22, a photoelectric conversion body 23 configured to receive light and generate photogenerated carriers, a sixth transparent conductive film 24, and a rear electrode layer 25. The photoelectric conversion body 23 has a structure in which a p-type semiconductor layer 23a, an i-type semiconductor layer 23b, and an n-type semiconductor layer 23c are sequentially stacked from the substrate 21 side. In the solar cell 20 having such a structure, similarly to the aforementioned first and second embodiments, the fifth transparent conductive film 22 is formed on the substrate 21 in the atmosphere containing hydrogen, and the sixth transparent conductive film 24 is formed on the n-type semiconductor layer 23c in the atmosphere not containing hydrogen. This can prevent degradation of the surface of the n-type semiconductor layer 23c (corresponding to "the second surface S2" of the aforementioned embodiments) . Moreover, the translucency of the fifth transparent conductive film 22 can be increased, and the electrical resistivity thereof can be reduced. Furthermore, since the p-type semiconductor layer 23a is formed after the fifth transparent conductive film 22 is formed, it is possible to prevent degradation of the surface of the p-type semiconductor layer 23a on the fifth transparent conductive film 22 side (corresponding to "the first surface S1" of the aforementioned embodiment). The structure of the solar cell 20 is not limited to the structure shown in Fig. 4 and may be a structure in which the fifth transparent conductive film 22, photoelectric conversion body 23, sixth transparent conductive film 24, rear electrode layer 25, and substrate 21 are stacked in this order. Moreover, the structure of the photoelectric conversion body 23 is not limited to the structure shown in Fig. 4 and may be a structure in which the n-type, i-type, and p-type semiconductor layers 23c, 23b, and 23a are sequentially stacked from the substrate 21 side or a structure in which the p-type and n-type semiconductor layers 23a and 23c are sequentially stacked from the substrate 21 side. For the p-type, i-type, and n-type semiconductor layers 23a, 23b, and 23c, p-type, i-type, and n-type semiconductor materials of amorphous Si, amorphous SiC, amorphous SiGe, microcrystalline Si, or the like can be used, respectively.

The aforementioned first and second embodiments describe about the case where the fine-line electrodes 2 and connecting electrodes 3 having the same shapes as those formed on the second major surface S2 of the solar cell substrate 1 are formed on the first major surface S1 of the solar cell substrate 1, but the present invention is not limited to such a case. For example, the fine-line electrodes 2 may be formed so as to cover substantially all over any one of the first and second major surfaces S1 and S2 of the solar cell substrate 1.

The aforementioned first and second embodiments describe the case where the photoelectric conversion body 11 includes the n-type substrate 11a, i-type semiconductor layer 11b, p-type semiconductor layer 11c, i-type semiconductor layer 11d, and n-type semiconductor layer 11e, but the present invention is not limited to such a case. Instead, the present invention is defined by the appended claims.

In the aforementioned second embodiment, the third and fourth transparent conductive films 12a and 12b having different hydrogen atom contents are formed as the first transparent conductive film 12 so that the hydrogen atom content of the part of the first transparent conductive film 12 on the opposite side to the n-type semiconductor layer 11e is higher than that of the part of the first transparent conductive film 12 on the n-type semiconductor layer 11e side. However, the present invention is not limited to this. Specifically, the first transparent conductive film 12 composed of a single film may be formed so that the hydrogen atom content thereof increases from the n-type semiconductor layer 11e side toward the opposite side to the n-type semiconductor layer 11e. The first transparent conductive film 12 having such a structure can be formed, for example, by employing the atmosphere not containing hydrogen as the condition for forming the first transparent conductive film 12 in a first part of the forming process and then increasing the supply amount of hydrogen atoms stepwisely so that the condition for forming the first transparent conductive film 12 can be the atmosphere containing hydrogen in a last part of the forming process.

As described above, the present invention naturally includes various embodiments which are not described herein. Accordingly, the technical scope of the present invention should be determined only by the matters to define the invention in the scope of claims regarded as appropriate based on the description.

### EXAMPLES

Hereinbelow, the solar cell according to the present invention is specifically described with examples. However, the present invention is not limited to the following examples and can be implemented with appropriate modification without changing the scope of the present invention.

### [Evaluation of Hydrogen Atom Content]

First, a comparison was made between hydrogen atom contents of transparent conductive films formed in the atmosphere not containing hydrogen and hydrogen atom contents of transparent conductive films formed in the atmosphere containing hydrogen. Specifically, hydrogen atom contents of test films A and B were measured by SIMS. Herein, the test films A were In₂O₃ films formed in the atmosphere not containing hydrogen by using a sputtering method, and the test films B were In₂O₃ formed in the atmosphere containing hydrogen by using a sputtering method. The measurement results of the hydrogen atom contents of the test films are shown in Table 1.

**[Table 1]**

| Test film | Hydrogen atom content (atoms/cc) |
|---|---|
| **A(In₂O₃ films formed in atmosphere not containing hydrogen)** | **1.0 × 10²⁰ - 5.2 × 10²⁰** |
| **B(In₂O₃ formed in atmosphere containing hydrogen)** | **1.6 × 10²¹ - 2.1 × 10²¹** |

As shown in Table 1, it was found that the hydrogen atom contents of the test films A, which were In₂O₃ films formed in the atmosphere not containing hydrogen, were about 1.0×10²⁰ to 5.2×10²⁰ (atoms/cc) while the hydrogen atom contents of the test films B, which were In₂O₃ films formed in the atmosphere containing hydrogen to actively incorporate hydrogen atoms, were 1.6×10²¹ to 2.1×10²¹ (atoms/cc) .

### [Evaluation of Output Power Characteristics]

Next, solar cells according to Examples 1 to 7 and Comparative Example were manufactured in the following manner, and comparisons were made in terms of characteristic values including open-circuit voltage V_{OC}, short-circuit current I_{SC}, fill factor FF, and output power Pₘₐₓ.

### <Example 1>

The solar cell according to Example 1 was manufactured as follows. First, an n-type single-crystalline silicon substrate (n-type substrate 11a) with a thickness of 200 µm was anisotropically etched with an alkaline aqueous solution to form fine roughness on the first and second major surfaces. The first and second major surfaces of the n-type substrate 11a were cleaned to remove impurities.

Next, on the second major surface side of the n-type single-crystalline silicon substrate (n-type substrate 11a), an i-type amorphous silicon layer (i-type semiconductor layer 11b) and a p-type amorphous silicon layer (p-type semiconductor layer 11c) were sequentially stacked by using a plasma CVD method or the like. Next, on the first major surface side of the n-type single-crystalline silicon substrate (n-type substrate 11a), an i-type amorphous silicon layer (i-type semiconductor layer 11d) and an n-type amorphous silicon layer (n-type semiconductor layer 11c) were sequentially stacked. The i-type amorphous silicon layer (i-type semiconductor layer 11b), p-type amorphous silicon layer (p-type semiconductor layer 11c), i-type amorphous silicon layer (i-type semiconductor layer 11d), and n-type amorphous silicon layer (n-type semiconductor layer 11c) each have a thickness of 5 mm. The photoelectric conversion body (photoelectric conversion body 11) was thus formed.

Next, on the p-type amorphous silicon layer (p-type semiconductor layer 11c), an IHO film (second transparent film 13) was formed by using a sputtering method in an Ar, O₂, and water vapor atmosphere (the atmosphere containing hydrogen). The IHO film (second transparent conductive film 13) was an In₂O₃ film formed in the atmosphere containing hydrogen to have a hydrogen atom content higher than that of an ITO film (first transparent conductive film 12) later described. The IHO film (second transparent conductive film 13) had a thickness of 1000 Å and was formed at room temperature.

Next, on the n-type amorphous silicon layer (n-type semiconductor layer 11e), the ITO film (first transparent conductive film 12) was formed by using a sputtering method in an Ar and O₂ atmosphere (atmosphere not containing hydrogen) . The ITO film (first transparent conductive film 12) had a thickness of 1000 Å and was formed at room temperature. In short, in Example 1, the ITO film (first transparent conductive film 12) was formed on the n-type amorphous silicon layer (n-type semiconductor layer 11e) after the IHO film (second transparent conductive film 13) was formed on the p-type amorphous silicon layer (p-type semiconductor layer 11c). The solar cell substrate (solar cell substrate 1) was thus formed.

Next, paste including a conductive filler mainly containing Ag and thermosetting resin was placed in predetermined patterns on the second and first major surfaces of the solar cell substrate (solar cell substrate 1) by using a screen printing method and was then annealed at 200°C. Fine-line electrodes (fine-line electrodes 2) and connecting electrodes (connecting electrodes 3) were thus formed. The solar cell according to Example 1 was formed in such a manner.

### <Example 2>

The solar cell according to Example 2 was manufactured in the following manner. First the photoelectric conversion body (photoelectric conversion body 11) was formed in the same way as Example 1 described above.

Next, on the n-type amorphous silicon layer (n-type semiconductor layer 11e), the ITO film (first transparent conductive film 12) was formed by using a sputtering method in an Ar and O₂ atmosphere (atmosphere not containing hydrogen) . The ITO film (first transparent conductive film 12) had a thickness of 1000 Å and was formed at room temperature.

Next, on the p-type amorphous silicon layer (p-type semiconductor layer 11c), an IHO film (second transparent film 13) was formed by using a sputtering method in an Ar, O₂, and water vapor atmosphere (the atmosphere containing hydrogen). The IHO film (second transparent conductive film 13) had a thickness of 1000 Å and was formed at room temperature . In short, in Example 2, the IHO film (second transparent conductive film 13) was formed on the p-type amorphous silicon layer (p-type semiconductor layer 11c) after the ITO film (first transparent conductive film 12) was formed on the n-type amorphous silicon layer (n-type semiconductor layer 11e) in a reverse order to that in Example 1. The solar cell substrate (solar cell substrate 1) was thus formed.

Next, fine-line electrodes (fine-line electrodes 2) and connecting electrodes (connecting electrodes 3) were formed in the same way as Example 1 described above. The solar cell according to Example 2 was formed in such a manner.

### <Example 3>

The solar cell according to Example 3 was manufactured in the following manner. First the photoelectric conversion body (photoelectric conversion body 11) was formed in the same way as Example 1 described above.

Next, on the n-type amorphous silicon layer (n-type semiconductor layer 11e), the ITO film (third transparent conductive film 12a) was formed by using a sputtering method in an Ar and O₂ atmosphere (atmosphere not containing hydrogen) . The ITO film (third transparent conductive film 12a) had a thickness of 500 Å and was formed at room temperature.

Next, on the p-type amorphous silicon layer (p-type semiconductor layer 11c), an IHO film (second transparent film 13) was formed by using a sputtering method in an Ar, O₂, and water vapor atmosphere (the atmosphere containing hydrogen). The IHO film (second transparent conductive film 13) had a thickness of 1000 Å and was formed at room temperature.

Next, on the ITO film (third transparent conductive film 12a), an IHO film (fourth transparent film 12b) was formed by using a sputtering method in an Ar, O₂, and water vapor atmosphere (the atmosphere containing hydrogen) . The IHO film (fourth transparent film 12b) was an In₂O₃ film formed in the atmosphere containing hydrogen to have a hydrogen atom content higher than that of the ITO film (third transparent conductive film 12a). The IHO film (fourth transparent film 12b) had a thickness of 500 Å and was formed at room temperature.

Next, fine-line electrodes (fine-line electrodes 2) and connecting electrodes (connecting electrodes 3) were formed in the same way as Example 2 described above. The solar cell according to Example 3 was formed in such a manner.

### <Example 4>

In Example 4, the thickness of the ITO film (third transparent conductive film 12a) in Example 3 described above was changed to 200 Å, and the thickness of the IHO film (fourth transparent conductive film 12b) was changed to 800 Å. The structures of the solar cells according to Example 4 and Example 3 described above were the same except that the thicknesses of the ITO film (third transparent conductive film 12a) and the IHO film (fourth transparent conductive film 12b) were changed.

### <Example 5>

In Example 5, the thickness of the ITO film (third transparent conductive film 12a) in Example 3 described above was changed to 150 Å, and the thickness of the IHO film (fourth transparent conductive film 12b) was changed to 850 Å. The structures of the solar cells according to Example 5 and Example 3 described above were the same except that the thicknesses of the ITO film (third transparent conductive film 12a) and the IHO film (fourth transparent conductive film 12b) were changed.

### <Example 6>

In Example 6, the thickness of the ITO film (third transparent conductive film 12a) in Example 3 described above was changed to 100 Å, and the thickness of the IHO film (fourth transparent conductive film 12b) was changed to 900 Å. The structures of the solar cells according to Example 6 and Example 3 described above were the same except that the thicknesses of the ITO film (third transparent conductive film 12a) and the IHO film (fourth transparent conductive film 12b) were changed.

### <Example 7>

In Example 7, the thickness of the ITO film (third transparent conductive film 12a) in Example 3 described above was changed to 75 Å, and the thickness of the IHO film (fourth transparent conductive film 12b) was changed to 925 Å. The structures of the solar cells according to Example 7 and Example 3 described above were the same except that the thicknesses of the ITO film (third transparent conductive film 12a) and the IHO film (fourth transparent conductive film 12b) were changed.

### <Example 8>

In Example 8, an ITO film (first transparent conductive film 12) was formed on an n-type amorphous silicon layer (n-type semiconductor layer 11e) of the photoelectric conversion body (photoelectric conversion body 11) in the same way as Example 2 described above. The ITO film (first transparent conductive film 12) had a thickness of 1000 Å and was formed at room temperature.

Next, on the p-type amorphous silicon layer (p-type semiconductor layer 11c), an IHTO film (second transparent film 13) was formed by using a sputtering method in an Ar, O₂, and water vapor atmosphere (the atmosphere containing hydrogen) . The IHTO film (second transparent conductive film 13) was an ITO film formed in the atmosphere containing hydrogen to have a high hydrogen atom content. The IHTO film had a thickness of 1000 Å and was formed at room temperature. The solar cell substrate (solar cell substrate 1) was thus formed.

Next, fine-line electrodes (fine-line electrodes 2) and connecting electrodes (connecting electrodes 3) were formed in the same way as Example 2 described above. The solar cell according to Example 8 was thus formed.

### <Example 9>

In Example 9, the photoelectric conversion body (photoelectric conversion body 11) was formed in the same way as Example 2 described above.

Next, an IWO film (first transparent conductive film 12) was formed on the n-type amorphous silicon layer (n-type semiconductor layer 11e) by using a sputtering method in the Ar and O₂ atmosphere (atmosphere not containing hydrogen) . The IWO film (first transparent conductive film 12) was an In₂O₃ film doped with tungsten (W) . The IWO film (first transparent conductive film 12) had a thickness of 1000 Å and was formed at room temperature.

Next, on the p-type amorphous silicon layer (p-type semiconductor layer 11c), an IHWO film (second transparent film 13) was formed by using a sputtering method in an Ar, O₂, and water vapor atmosphere (the atmosphere containing hydrogen). The IHWO film (second transparent conductive film 13) was an IWO film formed in the atmosphere containing hydrogen to have a high hydrogen atom content. The IHWO film (second transparent conductive film 13) had a thickness of 1000 Å and was formed at room temperature. The solar cell substrate (solar cell substrate 1) was thus formed.

Next, fine-line electrodes (fine-line electrodes 2) and connecting electrodes (connecting electrodes 3) were formed in the same way as Example 2 described above. The solar cell according to Example 9 was thus formed.

### <Example 10>

In Example 10, the photoelectric conversion body (photoelectric conversion body 11) was formed in the same way as Example 2 described above.

Next, an ICO film (first transparent conductive film 12) was formed on the n-type amorphous silicon layer (n-type semiconductor layer 11e) by using a sputtering method in the Ar and O₂ atmosphere (atmosphere not containing hydrogen) . The ICO film (first transparent conductive film 12) was an In₂O₃ film doped with cerium (Ce). The ICO film (first transparent conductive film 12) had a thickness of 1000 Å and was formed at room temperature.

Next, on the p-type amorphous silicon layer (p-type semiconductor layer 11c), an IHCO film (second transparent film 13) was formed by using a sputtering method in an Ar, O₂, and water vapor atmosphere (the atmosphere containing hydrogen). The IHCO film (second transparent conductive film 13) was an ICO film formed in the atmosphere containing hydrogen to have a high hydrogen atom content. The IHCO film (second transparent conductive film 13) had a thickness of 1000 Å and was formed at room temperature. The solar cell substrate (solar cell substrate 1) was thus formed.

Next, fine-line electrodes (fine-line electrodes 2) and connecting electrodes (connecting electrodes 3) were formed in the same way as Example 2 described above. The solar cell according to Example 10 was thus formed.

### <Comparative Example>

The solar cell according to Comparative Example was manufactured in the following manner. First the photoelectric conversion body (photoelectric conversion body 11) was formed in the same way as Example 1 described above.

Next, on the n-type amorphous silicon layer (n-type semiconductor layer 11e), a first IHO film was formed by using a sputtering method in an Ar, O₂, and water vapor atmosphere (the atmosphere containing hydrogen). The first IHO film had a thickness of 1000 Å and was formed at room temperature.

Next, on the p-type amorphous silicon layer (p-type semiconductor layer 11c), a second IHO film (second transparent film 13) was formed by using a sputtering method in an Ar, O₂, and water vapor atmosphere (the atmosphere containing hydrogen) . The second IHO film had a thickness of 1000 Å and was formed at room temperature. The solar cell substrate (solar cell substrate 1) was thus formed.

Next, fine-line electrodes (fine-line electrodes 2) and connecting electrodes (connecting electrodes 3) were formed in the same way as Example 1 described above. The solar cell according to Comparative Example was formed in such a manner.

### <Evaluation Results of Output Power Characteristics>

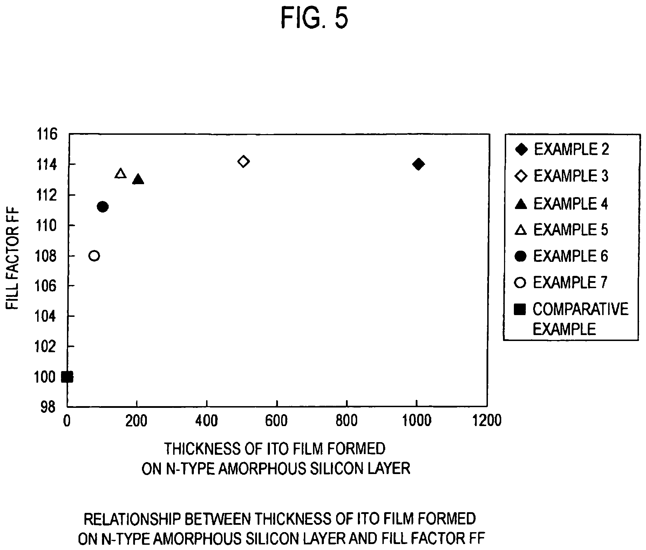

The characteristic values including the open-circuit voltage V_{OC}, short-circuit current I_{SC}, fill factor FF, and output power Pₘₐₓ were measured for the solar cells according to Examples 1 to 10 and Comparative Example described above. The results of the measurement are shown in Table 2. Table 2 shows the characteristic values of the solar cells according to Examples 1 to 10 normalized with the characteristic values of the solar cell according to Comparative Example set to 100. Fig. 5 shows a relationship between the thickness of the ITO film formed on the n-type amorphous silicon layer (n-type semiconductor layer 11e) and the fill factor FF. Fig. 5 shows the fill factors FF of the solar cells according to Examples 2 to 7 normalized with the fill factor FF of the solar cell according to Comparative Example set to 100. Moreover, in the solar cell according to Comparative Example, the IHO layer was formed on the n-type amorphous silicon layer (n-type semiconductor layer 11e), and the ITO film was not formed thereon. In Fig. 5, the ITO film thickness (Å) of the solar cells according to Comparative Example is therefore zero.

**[Table 2]**

| | Open-circuit voltage (Voc) | Short-circuit current (Isc) | Fill factor (FF) | Output power (Pmax) |
|---|---|---|---|---|
| Example 1 | **100.7** | **99.8** | **111.0** | **111.5** |
| Example 2 | **100.9** | **99.6** | **113.8** | **114.4** |
| Example 3 | **100.7** | **99.7** | **114.1** | **114.5** |
| Example 4 | **100.5** | **99.5** | **113.0** | **113.1** |
| Example 5 | **100.6** | **99.9** | **113.4** | **114.0** |
| Example 6 | **100.5** | **100.2** | **111.2** | **112.0** |
| Example 7 | **100.4** | **99.4** | **107.9** | **107.8** |
| Example 8 | **100.7** | **99.5** | **117.5** | **117.7** |
| Example 9 | **100.6** | **99.9** | **117.0** | **117.6** |
| Example 10 | **100.2** | **100.3** | **116.5** | **117.1** |
| Comparative Example | **100.0** | **100.0** | **100.0** | **100.0** |

As shown in Table 2, it was found that, in comparison with the solar cell according to Comparative Example, the solar cells according to Examples 1 to 10 were improved in the fill factor FF and therefore improved in the output power Pmax. This is because, in each of Examples 1 to 10, the transparent conductive film was formed in the atmosphere not containing hydrogen on the n-type amorphous silicon layer (n-type semiconductor layer 11e) forming the first major surface of the photoelectric conversion body (photoelectric conversion body 11). The degradation of the surface of the n-type amorphous silicon layer (n-type semiconductor layer 11e) was prevented in each of Examples 1 to 10 in comparison with Comparative Example in which the transparent conductive film was formed on the n-type amorphous silicon layer (n-type semiconductor layer 11e) in the atmosphere containing hydrogen.

As shown in Table 2, it was found that the solar cell according to Example 2 was further improved in the fill factor FF and output power Pmax in comparison with the solar cell according to Example 1. This is because the ITO film (first transparent conductive film 12) was formed on the n-type amorphous silicon layer (n-type semiconductor layer 11e) in the atmosphere not containing hydrogen before the IHO film (second transparent conductive film 13) was formed on the p-type amorphous silicon layer (p-type semiconductor layer 11c) in the atmosphere containing hydrogen. The surface of the n-type amorphous silicon layer (n-type semiconductor layer 11e) was therefore protected by the ITO film (first transparent conductive film 12). Accordingly, the surface of the n-type amorphous silicon layer (n-type semiconductor layer 11e) was less likely to be degraded when the photoelectric conversion body (photoelectric conversion body 11) was exposed to the atmosphere containing hydrogen.

As shown in Table 2, it was found that the solar cells according to Examples 8 to 10 were further improved in the fill factor FF and output power Pmax in comparison with the solar cell according to Example 2. This is because the IHTO film containing metallic dopant had a contact resistance with the p-type amorphous silicon layer (p-type semiconductor layer 11c) lower than that of the IHO film not containing metallic dopant.

Moreover, as shown in Fig. 5, the fill factor FF of the solar cells increased as the thickness of the ITO film (the first transparent conductive film 12 in Example 2 and the third transparent conductive film 12a in Examples 3 to 7) formed on the n-type amorphous silicon layer (n-type semiconductor layer 11e) increased from 0 to 150 Å. The fill factor FF of the solar cells remained substantially constant when the thickness of the ITO film was 150 Å or more. Accordingly, it has been found that it is preferable to form an ITO film having a thickness of 150 Å or more on the n-type amorphous silicon layer (n-type semiconductor layer 11e).

### INDUSTRIAL AVAILABILITY

According to the present invention, it is possible to provide a solar cell with the surface characteristics of the photoelectric conversion body prevented from being degraded and a method for manufacturing the same. Hence, the present invention is useful in the field of sunlight power generation.

## Claims

1. A solar cell (10), comprising:
a photoelectric conversion body (11) configured to generate photogenerated carriers upon receiving light;
a first transparent conductive film (12) formed on a first major surface (S1) of the photoelectric conversion body (11); and
a second transparent conductive film (13) formed on a second major surface (S2) provided on an side opposite to the first major surface (S1), wherein
the first major surface (S1) is formed by an n-type amorphous semiconductor layer (11e), and
the second major surface (S2) is formed by a p-type amorphous semiconductor layer (11c),
**characterized in that**:
the photoelectric conversion body (11) includes an n-type single-crystalline silicon substrate (11a); and
the hydrogen atom content of the first transparent conductive film (12) is lower than that of the second transparent conductive film (13).

2. The solar cell (10) according to claim 1, wherein the hydrogen atom content of a part (12b) of the first transparent conductive film (12) on an opposite side of the first transparent conductive film (12) to the n-type semiconductor layer (11e) is higher than the hydrogen atom content of a part (12a) of the first transparent conductive film (12) in the vicinity of the interface between the n-type semiconductor layer (11e) and the first transparent conductive film (12).

3. The solar cell (10) according to claim 1 or 2, wherein a part (12a) of the first transparent conductive film (12) in the vicinity of the interface between the n-type semiconductor layer (11e) and the first transparent conductive film (12) is made of a different material from a material of a part (12b) of the first transparent conductive film (12) on the opposite side of the first transparent conductive film (12) to the n-type semiconductor layer (11e).

4. The solar cell (10) according to any one of claims 1 to 3, wherein the first transparent conductive film (12) and/or the second transparent conductive film (13) is made of a metal oxide.

5. A method for manufacturing a solar cell (10) including a photoelectric conversion body (11) configured to generate photogenerated carriers upon receiving light, the method comprising:
a step A of forming a first transparent conductive film (12) in an atmosphere not containing hydrogen on a first major surface (S1) of the photoelectric conversion body (11); and
a step B of forming a second transparent conductive film (13) in an atmosphere containing hydrogen on a second major surface (S2) provided on an side opposite to the first major surface (S1), wherein
the first major surface (S1) is formed by an n-type amorphous semiconductor layer (11e),
the second major surface (S2) is formed by a p-type amorphous semiconductor layer (11c), and
in the step B, the second transparent conductive film (13) is formed while hydrogen atoms are being supplied
**characterized in that**:
the photoelectric conversion body (11) includes an n-type single-crystalline silicon substrate (11a); and
the hydrogen atom content of the first transparent conductive film (12) is lower than that of the second transparent conductive film (13).

6. The method for manufacturing the solar cell (10) according to claim 5, wherein the step B is performed after the step A is performed.

## Patentansprüche

1. Solarzelle (10), Folgendes umfassend:
einen fotoelektrischen Umwandlungskörper (11), der konfiguriert ist, um beim Empfangen von Licht fotogenerierte Träger zu erzeugen;
einen ersten transparenten leitfähigen Film (12), der auf einer ersten Hauptfläche (S1) des fotoelektrischen Umwandlungskörpers (11) ausgebildet ist; und
einen zweiten transparenten leitfähigen Film (13), der auf einer zweiten Hauptfläche (S2) ausgebildet ist, welche auf einer der ersten Hauptfläche (S1) entgegengesetzten Seite bereitgestellt ist, wobei
die erste Hauptfläche (S1) durch eine amorphe n-Typ-Halbleiterschicht (11e) ausgebildet ist und wobei
die zweite Hauptfläche (S2) durch eine amorphe p-Typ-Halbleiterschicht (11c) ausgebildet ist,
**dadurch gekennzeichnet, dass**
der fotoelektrische Umwandlungskörper (11) ein einkristallines n-Typ-Siliziumsubstrat (11a) umfasst, und dass
der Wasserstoffatomgehalt des ersten transparenten leitfähigen Films (12) geringer ist als jener des zweiten transparenten leitfähigen Films (13).

2. Solarzelle (10) nach Anspruch 1, wobei der Wasserstoffatomgehalt eines Teils (12b) des ersten transparenten leitfähigen Films (12) auf einer zur n-Typ-Halbleiterschicht (11e) entgegengesetzten Seite des ersten transparenten leitfähigen Films (12) höher ist als der Wasserstoffatomgehalt eines Teils (12a) des ersten transparenten leitfähigen Films (12) in der Nähe der Grenzfläche zwischen der n-Typ-Halbleiterschicht (11e) und dem ersten transparenten leitfähigen Film (12).

3. Solarzelle (10) nach Anspruch 1 oder 2, wobei ein Teil (12a) des ersten transparenten leitfähigen Films (12) in der Nähe der Grenzfläche zwischen der n-Typ-Halbleiterschicht (11e) und dem ersten transparenten leitfähigen Film (12) aus einem anderen Material hergestellt ist als ein Material eines Teils (12b) des ersten transparenten leitfähigen Films (12) auf der zur n-typ-Halbleiterschicht (11e) entgegengesetzten Seite des ersten transparenten leitfähigen Films (12).

4. Solarzelle (10) nach einem der Ansprüche 1 bis 3, wobei der erste transparente leitfähige Film (12) und/oder der zweite transparente leitfähige Film (13) aus einem Metalloxid hergestellt sind.

5. Verfahren zur Herstellung einer Solarzelle (10), umfassend einen fotoelektrischen Umwandlungskörper (11), der konfiguriert ist, um beim Empfangen von Licht fotogenerierte Träger zu erzeugen, wobei das Verfahren Folgendes umfasst:
einen Schritt A des Ausbildens eines ersten transparenten leitfähigen Films (12) in einer Atmosphäre, die keinen Wasserstoff enthält, auf einer ersten Hauptfläche (S1) des fotoelektrischen Umwandlungskörpers (11); und
einen Schritt B des Ausbildens eines zweiten transparenten leitfähigen Films (13) in einer Atmosphäre, die Wasserstoff enthält, auf einer zweiten Hauptfläche (S2), welche auf einer der ersten Hauptfläche (S1) entgegengesetzten Seite bereitgestellt ist, wobei
die erste Hauptfläche (S1) durch eine amorphe n-Typ-Halbleiterschicht (11e) ausgebildet ist und wobei
die zweite Hauptfläche (S2) durch eine amorphe p-Typ-Halbleiterschicht (11c) ausgebildet ist, und wobei
in Schritt B der zweite transparente leitfähige Film (13) ausgebildet wird, während Wasserstoffatome zugeführt werden,
**dadurch gekennzeichnet, dass**
der fotoelektrische Umwandlungskörper (11) ein einkristallines n-Typ-Siliziumsubstrat (11a) umfasst, und dass
der Wasserstoffatomgehalt des ersten transparenten leitfähigen Films (12) geringer ist als jener des zweiten transparenten leitfähigen Films (13).

6. Verfahren zur Herstellung einer Solarzelle (10) nach Anspruch 5, wobei Schritt B nach Schritt A durchgeführt wird.

## Revendications

1. Cellule solaire (10) comprenant :
un corps de conversion photoélectrique (11) configuré pour générer des porteurs photogénérés lors de la réception de lumière ;
un premier film conducteur transparent (12) formé sur une première surface principale (51) du corps de conversion photoélectrique (11) ; et
un second film conducteur transparent (13) formé sur une seconde surface principale (S2) prévue sur un côté opposé à la première surface principale (51), dans lequel
la première surface principale (S1) est formée par une couche semi-conductrice amorphe de type n (11e), et
la seconde surface principale (S2) est formée par une couche semi-conductrice amorphe de type p (11c),
**caractérisé en ce que** :
le corps de conversion photoélectrique (11) comprend un substrat de silicium monocristallin de type n (11a) ; et
la teneur en atomes d'hydrogène du premier film conducteur transparent (12) est inférieure à celle du second film conducteur transparent (13).

2. Cellule solaire (10) selon la revendication 1, dans laquelle la teneur en atomes d'hydrogène d'une partie (12b) du premier film conducteur transparent (12) sur un côté du premier film conducteur transparent (12) opposé à la couche semi-conductrice de type n (11e) est supérieure à la teneur en atomes d'hydrogène d'une partie (12a) du premier film conducteur transparent (12) au voisinage de l'interface entre la couche semi-conductrice de type n (11e) et le premier film conducteur transparent (12).

3. Cellule solaire (10) selon la revendication 1 ou 2, dans laquelle une partie (12a) du premier film conducteur transparent (12) au voisinage de l'interface entre la couche semi-conductrice de type n (11e) et le premier film conducteur transparent (12) est constituée d'un matériau différent du matériau d'une partie (12b) du premier film conducteur transparent (12) sur le côté du premier film conducteur transparent (12) opposé à la couche semi-conductrice de type n (11e).

4. Cellule solaire (10) selon l'une quelconque des revendications 1 à 3, dans laquelle le premier film conducteur transparent (12) et/ou le second film conducteur transparent (13) est constitué d'un oxyde métallique.

5. Procédé de fabrication d'une cellule solaire (10) comprenant un corps de conversion photoélectrique (11) configuré pour générer des supports photogénérés lors de la réception de lumière, le procédé comprenant :
une étape A de formation d'un premier film conducteur transparent (12) dans une atmosphère ne contenant pas d'hydrogène sur une première surface principale (S1) du corps de conversion photoélectrique (11) ; et
une étape B de formation d'un second film conducteur transparent (13) dans une atmosphère contenant de l'hydrogène sur une seconde surface principale (S2) prévue sur un côté opposé à la première surface principale (S1), dans lequel
la première surface principale (S1) est formée par une couche semi-conductrice amorphe de type n (11e),
la seconde surface principale (S2) est formée par une couche semi-conductrice amorphe de type p (11c), et
à l'étape B, le second film conducteur transparent (13) est formé pendant que des atomes d'hydrogène sont fournis,
**caractérisé en ce que** :
le corps de conversion photoélectrique (11) comprend un substrat de silicium monocristallin de type n (11a) ; et
la teneur en atomes d'hydrogène du premier film conducteur transparent (12) est inférieure à celle du second film conducteur transparent (13).

6. Procédé de fabrication de la cellule solaire (10) selon la revendication 5, dans lequel l'étape B est effectuée après la réalisation de l'étape A.
